# EUROPEAN PATENT APPLICATION

(11) **EP 4 486 076 A1**
(43) Date of publication of application: **01.01.2025**
(21) Application number: 23759787.7
(22) Date of filing: 14.02.2023
(51) Int. Cl.: H05K 1/03, C08G 59/18, C08J 5/24, C08K 3/22, C08K 3/36, C08K 5/3415, C08L 63/00

(54) **RESIN COMPOSITION, PREPREG, FILM WITH RESIN, METAL FOIL WITH RESIN, METAL-CLADDED LAMINATE AND PRINTED WIRING BOARD**

(30) Priority: 22.02.2022 JP 2022026096
(71) Applicant: Panasonic Intellectual Property Management Co., Ltd., Kadoma-shi, Osaka 571-0057 (JP)
(72) Inventor: HASHIMOTO, Akito, Kadoma-shi, Osaka 571-0057 (JP); FUJISAWA, Hiroyuki, Kadoma-shi, Osaka 571-0057 (JP); ENDOU, Kazuei, Kadoma-shi, Osaka 571-0057 (JP); YAMADA, Takahiro, Kadoma-shi, Osaka 571-0057 (JP)
(74) Representative: Appelt, Christian W.
(86) International application number: PCT/JP2023/005035
(87) International publication number: WO 2023/162785

(57) **Abstract**

The problem to be overcome by the present disclosure is to provide a resin composition contributing to reducing the chances of causing ion migration and achieving a low coefficient of thermal expansion. A resin composition according to the present disclosure contains an epoxy compound (A), a maleimide compound (B), a curing agent (C), and an inorganic filler (D). The inorganic filler (D) includes a silica filler (D1) and a silica-treated magnesium hydroxide (D2) that is a magnesium hydroxide subjected to surface treatment with silica.

## Description

### Technical Field

The present disclosure generally relates to a resin composition, a prepreg, a film with resin, a sheet of metal foil with resin, a metal-clad laminate, and a printed wiring board. More particularly, the present disclosure relates to a resin composition containing an epoxy compound, a prepreg, a film with resin, a sheet of metal foil with resin, a metal-clad laminate, and a printed wiring board.

### Background Art

Patent Literature 1 discloses a prepreg, of which a sheet-shaped base member is impregnated with a phosphorus-containing epoxy resin composition. The phosphorus-containing epoxy resin composition contains a phosphorus-containing epoxy resin and a curing agent. The phosphorus-containing epoxy resin is obtained by producing a reaction between a phosphorus-containing organic compound and a type of epoxy resin. Furthermore, the phosphorus-containing organic compound is obtained by producing a reaction between a type of quinone compound and a type of organic phosphorus compound having an active hydrogen atom bonded to a phosphorus atom.

The prepreg of Patent Literature 1 contains the phosphorus-containing epoxy resin. Thus, a printed wiring board formed by using this prepreg would have flame retardance.

However, Patent Literature 1 provides no specific measures for reducing ion migration or measures for achieving a low coefficient of thermal expansion. Directly speaking, the "ion migration" refers to a phenomenon that the migration of ions between the electrodes of a printed wiring board causes precipitation of a metal that leads to deterioration of electrical insulation properties.

### Citation List

### Patent Literature

Patent Literature 1: JP 2001-288247 A

### Summary of Invention

An object of the present disclosure is to provide a resin composition, a prepreg, a film with resin, a sheet of metal foil with resin, a metal-clad laminate, and a printed wiring board, all of which contribute to reducing the chances of causing the ion migration and achieving a low coefficient of thermal expansion.

A resin composition according to an aspect of the present disclosure contains an epoxy compound (A), a maleimide compound (B), a curing agent (C), and an inorganic filler (D). The inorganic filler (D) includes a silica filler (D1) and a silica-treated magnesium hydroxide (D2) that is a magnesium hydroxide subjected to surface treatment with silica.

A prepreg according to another aspect of the present disclosure includes: a resin layer containing the resin composition described above; and a base member impregnated with the resin composition.

A film with resin according to still another aspect of the present disclosure includes: a resin layer containing the resin composition described above; and a supporting film supporting the resin layer.

A sheet of metal foil with resin according to yet another aspect of the present disclosure includes: a resin layer containing the resin composition described above; and a sheet of metal foil bonded to the resin layer.

A metal-clad laminate according to yet another aspect of the present disclosure includes: an insulating layer containing either a cured product of the resin composition described above or a cured product of the prepreg described above; and a metal layer bonded to the insulating layer.

A printed wiring board according to yet another aspect of the present disclosure includes: an insulating layer containing either a cured product of the resin composition described above or a cured product of the prepreg described above; and conductor wiring bonded to the insulating layer.

### Brief Description of Drawings

FIG. 1 is a schematic cross-sectional view illustrating a prepreg according to an exemplary embodiment of the present disclosure;
FIG. 2A is a schematic cross-sectional view illustrating a film with resin (and with no protective film) according to the exemplary embodiment of the present disclosure;
FIG. 2B is a schematic cross-sectional view illustrating a film with resin (and with a protective film) according to the exemplary embodiment of the present disclosure;
FIG. 3 is a schematic cross-sectional view illustrating a sheet of metal foil with resin according to the exemplary embodiment of the present disclosure;
FIG. 4 is a schematic cross-sectional view illustrating a metal-clad laminate according to the exemplary embodiment of the present disclosure; and
FIG. 5 is a schematic cross-sectional view illustrating a printed wiring board according to the exemplary embodiment of the present disclosure.

### Description of Embodiments

### 1. Overview

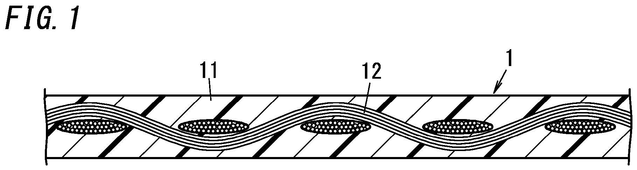

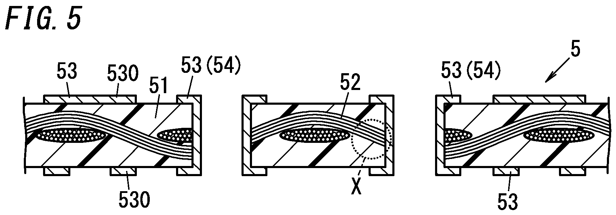

A resin composition according to an exemplary embodiment may be used mainly as a material for a printed wiring board 5 (refer to FIG. 5). Specific examples of materials for the printed wiring board 5 include a prepreg 1, a film 2 with resin, a sheet of metal foil 3 with resin, and a metal-clad laminate 4 (refer to FIGS. 1-4). However, these are only examples and should not be construed as limiting.

A resin composition according to this embodiment contains an epoxy compound (A), a maleimide compound (B), a curing agent (C), and an inorganic filler (D). The inorganic filler (D) contains a silica filler (D1) and a silica-treated magnesium hydroxide (D2). The silica-treated magnesium hydroxide (D2) is a magnesium hydroxide subjected to surface treatment with silica.

The resin composition according to this embodiment may reduce the chances of causing ion migration and achieve a low coefficient of thermal expansion.

As used herein, the "ion migration" could be caused by CAF (conductive anodic filament). In CAF, metal ions precipitated from the anode are precipitated mainly at the boundary between the glass fiber and the resin in the inner layer of the board. The CAF is mainly generated in the inner layer of the board (in, for example, portion X shown in FIG. 5).

### 2. Details

### <Resin composition>

A resin composition contains an epoxy compound (A), a maleimide compound (B), a curing agent (C), and an inorganic filler (D). The resin composition may further contain a curing catalyst (E) and/or a flame retardant (F). The resin composition may further contain other components (G). As used herein, the phrase "X and/or Y" means at least one selected from the group consisting of X and Y.

The resin composition has thermosetting properties. When heated, the resin composition turns into a semi-cured product. When further heated, the resin composition turns into a cured product. The semi-cured product is a substance in a semi-cured state, and the cured product is a substance in a cured state (insoluble and non-meltable state). As used herein, the semi-cured state refers to a state in an intermediate stage (stage B) of the curing reaction. The intermediate stage is a stage between a varnished stage (stage A) and a cured stage (stage C).

Next, respective constituent components of the resin composition will be described.

### «Epoxy resin (A)»

The epoxy compound (A) is a prepolymer and is a compound having at least two epoxy groups in its molecule. The epoxy compound (A) will be hereinafter sometimes referred to as an "epoxy resin." Generally speaking, the term "resin" refers to two different types of resins, namely, a resin as a material which has not been cross-linked yet and a resin as a cross-linked product (final product). As used herein, the "resin" basically refers to the former type of a resin.

Examples of the epoxy compound (A) include, without limitation, naphthalene epoxy resins, cresol-novolac epoxy resins, bisphenol A epoxy resins, bisphenol F epoxy resins, bisphenol S epoxy resins, phenol-novolac epoxy resins, alkyl phenol-novolac epoxy resins, aralkyl epoxy resins, biphenol epoxy resins, dicyclopentadiene epoxy resins, epoxidized products of condensate of phenols and aromatic aldehyde having a phenolic hydroxyl group, triglycidyl isocyanurate, and alicyclic epoxy resins. The epoxy compound (A) may include at least one epoxy resin selected from this group.

The epoxy compound (A) preferably has a naphthalene structure in its molecule. This may improve the heat resistance. The heat resistance is improved probably because the naphthalene structure, which is a condensed polycyclic structure, would decrease the molecular motion to cause an increase in glass transition temperature (Tg).

### «Maleimide compound (B)»

Examples of the maleimide compound (B) include, without limitation, compounds having two or more maleimide groups in their molecule, compounds having one maleimide group in their molecule, compounds having a phenylmaleimide group in their molecule, and modified maleimide compounds. Among other things, compounds having two maleimide groups in their molecule (bismaleimide) are preferred. Bismaleimide has a rigid chemical structure and high reactivity. Therefore, adding bismaleimide to a resin composition increases the chances of achieving sufficient strength (high elasticity) and heat resistance (high Tg).

The following are examples of compounds having a phenylmaleimide group in their molecule. Note that these are only examples and should not be construed as limiting. Also, commercially available products that may be used are also cited in parentheses.
- 4,4'-diphenylmethane bismaleimide (product name "BMI-1000" manufactured by Daiwa Fine Chemicals Co., Ltd.,);
- Polyphenylmethane maleimide (product name "BMI-2300" manufactured by Daiwa Fine Chemicals Co., Ltd.,);
- m-phenylene bismaleimide (product name "BMI-3000" manufactured by Daiwa Fine Chemicals Co., Ltd.,);
- Bisphenol A diphenyl ether bismaleimide (product name "BMI-4000" manufactured by Daiwa Fine Chemicals Co., Ltd.,);
- 3,3'-dimethyl-5,5'-diethyl-4,4'-diphenylmethane bismaleimide (product name "BMI-5100" manufactured by Daiwa Fine Chemicals Co., Ltd.,);
- 4-methyl-1,3-phenylene bismaleimide (product name "BMI-7000" manufactured by Daiwa Fine Chemicals Co., Ltd.,);
- 1,6'-bismaleimide-(2,2,4-trimethyl) hexane (product name "BMI-TMH" manufactured by Daiwa Fine Chemicals Co., Ltd.,);
- Biphenyl-aralkyl maleimide compound (product name "MIR-3000-70T" manufactured by Nippon Kayaku Co., Ltd.,); and
- A compound having a phenyl maleimide group and an arylene structure substituted at the meta position in its molecule.

Examples of the modified maleimide compounds include, without limitation, a modified maleimide compound, of which the molecule is partially modified with amine, a modified maleimide compound, of which the molecule is partially modified with silicone, and a modified maleimide compound, of which the molecule is partially modified with amine and silicone.

Note that the maleimide compound (B) may consist of only one type or may include two or more types, whichever is appropriate.

### «Curing agent (C)»

Any curing agent (C) may be used without limitation. It is preferable that the curing agent (C) contain dicyandiamide (C1) and/or a polyfunctional phenolic compound (C2). This may improve adhesiveness and flame retardance.

The polyfunctional phenolic compound (C2) is a compound having two or more phenolic hydroxy groups in its molecule. The polyfunctional phenolic compound (C2) preferably includes a phosphorus-containing compound (C21). This may further improve the flame retardance.

As used herein, the "adhesiveness" refers to the adhesion between an insulating layer 41 and a metal layer 43 in a metal-clad laminate 4 and the adhesion between an insulating layer 51 and conductor wiring 53 in a printed wiring board 5. That is to say, if the curing agent (C) contains dicyandiamide (C1) and/or a polyfunctional phenolic compound (C2), the adhesion between the insulating layer 41 and the metal layer 43 improves in the metal-clad laminate 4. In addition, the adhesion between the insulating layer 51 and the conductor wiring 53 also improves in the printed wiring board 5. As used herein, the "insulating layer" refers to a layer having electrical insulation properties.

If the curing agent (C) contains active hydrogen groups, the total amount of the active hydrogen groups in the curing agent (C) is preferably equal to or greater than 0.2 equivalents with respect to 1 equivalent of the epoxy group of the epoxy compound (A). Setting the total amount of active hydrogen groups in the curing agent (C) at 0.2 equivalents or more may reduce the chances of causing a decrease in heat resistance and adhesiveness. On the other hand, the total amount of the active hydrogen groups in the curing agent (C) is preferably equal to or less than 0.5 equivalents with respect to 1 equivalent of the epoxy group of the epoxy compound (A). Setting the total amount of active hydrogen groups of the curing agent (C) at 0.5 equivalents or less may reduce the chances of causing a decrease in adhesiveness, flame retardance, and moldability. Specifically, as for moldability, this may reduce the chances of the gel time becoming too short.

### «Inorganic filler (D)»

The inorganic filler (D) contains a silica filler (D1) and a silica-treated magnesium hydroxide (D2). Optionally, the inorganic filler (D) may further include additional inorganic fillers (D3) other than the silica filler (D1) and the silica-treated magnesium hydroxide (D2).

### [Silica filler (D1)]

The silica filler (D1) imparts low thermal expansivity to a cured product of the resin composition. The silica filler (D1) preferably includes a spherical silica. Examples of the silica filler (D1) include, without limitation, a fused silica and a crystal silica.

### [Silica-treated magnesium hydroxide (D2)]

The silica-treated magnesium hydroxide (D2) imparts flame retardance to the cured product of the resin composition by having the heat of combustion absorbed into decomposed water produced during heating.

The silica-treated magnesium hydroxide (D2) is a magnesium hydroxide subjected to surface treatment with a silica such as a colloidal silica. The silica-treated magnesium hydroxide (D2) includes a magnesium hydroxide having a silica on its surface and a magnesium hydroxide having a composite of a silica and an alumina on its surface.

As used herein, the expression "magnesium hydroxide has a silica on its surface" means, for example, that the silica adheres to the surface of a particle of the magnesium hydroxide. Furthermore, the forms of adhesion include, for example, coating and/or supporting.

The surface of the magnesium hydroxide is preferably coated with the silica. In that case, the silica forms a layer, for example. When the silica forms a layer, the layer may be formed by particles of the silica that are connected together. The silica may coat the surface of the magnesium hydroxide at least partially. That is to say, the surface of the magnesium hydroxide may be coated with the silica either entirely or only partially, whichever is appropriate.

On the other hand, the expression "the silica is supported on the magnesium hydroxide" herein means that a powdered silica is fixed on the surface of the magnesium hydroxide serving as a catalytic support. In this case, the silica may be supported on at least a part of the surface of the magnesium hydroxide. That is to say, the silica may be supported on the entire surface, or only a part of the surface, of the magnesium hydroxide, whichever is appropriate.

The magnesium hydroxide in the silica-treated magnesium hydroxide (D2) may contribute to reducing the chances of causing ion migration. On the other hand, the silica in the silica-treated magnesium hydroxide (D2) may contribute to improving the desmear performance. If the surface is not treated with the silica, then the smear would tend to be removed excessively, thus possibly resulting in a hole with a deformed shape or too large a diameter through the desmear process.

The mean particle size of the silica-treated magnesium hydroxide (D2) is preferably equal to or greater than 0.5 µm, and more preferably equal to or greater than 1.0 µm. On the other hand, the mean particle size of the silica-treated magnesium hydroxide (D2) is preferably equal to or less than 10 µm and more preferably equal to or less than 5.0 µm. As used herein, the "mean particle size" refers to the particle size at a cumulative value of 50% in a particle size distribution obtained by laser diffraction/scattering method.

The proportion of the silica-treated magnesium hydroxide (D2) which has been treated with silica (hereinafter referred to as a "silica-treated proportion") is preferably equal to or greater than 1 part by mass with respect to 100 parts by mass of the magnesium hydroxide. Setting the silica-treated proportion at 1 part by mass or more allows the surface of the magnesium hydroxide to be sufficiently treated and reduces the chances of removing smear excessively through the desmear process. On the other hand, the silica-treated proportion of the silica-treated magnesium hydroxide (D2) is preferably equal to or less than 10 parts by mass with respect to 100 parts by mass of the magnesium hydroxide. Setting the silica-treated proportion at 10 parts by mass or less reduce the chances of causing not only a decrease in flame retardance but also the ion migration as well.

The content of the silica-treated magnesium hydroxide (D2) is preferably equal to or greater than 1 part by mass, more preferably equal to or greater than 3 parts by mass, and even more preferably equal to or greater than 4 parts by mass, with respect to 100 parts by mass in total of the silica filler (D1) and the silica-treated magnesium hydroxide (D2). Setting the content of the silica-treated magnesium hydroxide (D2) at 1 parts by mass or more may further reduce the chances of causing the ion migration. On the other hand, the content of the silica-treated magnesium hydroxide (D2) is preferably equal to or less than 20 part by mass, more preferably equal to or less than 10 parts by mass, and even more preferably equal to or less than 7 parts by mass, with respect to 100 parts by mass in total of the silica filler (D1) and the silica-treated magnesium hydroxide (D2). Setting the content of the silica-treated magnesium hydroxide (D2) at 20 parts by mass or less may reduce the chances of causing a decrease in flame retardance.

### [Additional inorganic fillers (D3)]

The additional inorganic fillers (D3) are inorganic fillers other than the silica filler (D1) and the silica-treated magnesium hydroxide (D2). Examples of the additional inorganic fillers (D3) include, without limitation, talc, alumina (aluminum oxide), aluminum hydroxide, magnesium hydroxide, glass, and molybdenum compounds adhered to the surfaces of particles of these compounds. Note that adhesion as used herein refers to, for example, coating and/or supporting.

In this embodiment, examples of the molybdenum compound include, without limitation, zinc molybdate, calcium zinc molybdate compounds, and calcium molybdate compounds.

The additional inorganic filler (D3) preferably contains talc zinc molybdate. The talc zinc molybdate is produced by causing zinc molybdate to adhere to the surface of talc particles.

The content of the additional inorganic fillers (D3) is preferably equal to or greater than 2 parts by mass with respect to 100 parts by mass in total of the silica filler (D1), the silica-treated magnesium hydroxide (D2), and the additional inorganic fillers (D3). Setting the content of the additional inorganic fillers (D3) at 2 parts by mass or more enables achieving effects unique to the additional inorganic fillers (D3). For example, using talc zinc molybdate as the additional inorganic fillers (D3) improves the drillability. That is to say, this would reduce the wear rate of the drill and improve the hole position accuracy.

On the other hand, the content of the additional inorganic fillers (D3) is preferably equal to or less than 50 parts by mass, and more preferably equal to or less than 40 parts by mass, with respect to 100 parts by mass in total of the silica filler (D1), the silica-treated magnesium hydroxide (D2), and the additional inorganic fillers (D3). Setting the content of the additional inorganic fillers (D3) at 50 parts by mass or less may reduce the chances of causing a decrease in heat resistance and further reduce the chances of causing ion migration.

The inorganic filler (D) may be surface-treated with a coupling agent. The coupling agent preferably has, in one molecule, a reactive group which chemically bonds to an inorganic material and a reactive group which chemically bonds to an organic material. Specific examples of such reactive groups that chemically bond to inorganic materials include ethoxy groups and methoxy groups. Specific examples of such reactive groups that chemically bond to organic materials include epoxy groups, amino groups, isocyanate groups, hydroxy groups, and acid anhydride groups.

Examples of the coupling agent include, without limitation, a silane coupling agent. The silane coupling agent includes, for example, epoxy silanes, amino silanes, isocyanate silanes, and acid anhydride silanes. Specific examples of the epoxy silanes include 3-glycidoxypropyl trimethoxysilane. Specific examples of the aminosilane include 3-aminopropyltriethoxysilane. Specific examples of the isocyanate silanes include 3-isocyanatopropyltriethoxysilane.

### «Curing catalyst (E)»

The curing catalyst (E) is synonymous with a curing accelerator. The curing catalyst (E) may be, but does not have to be, selected from the group consisting of, for example: imidazoles such as 2-ethyl-4-methylimidazole, 2-methylimidazole, and 2-phenyl-4-methylimidazole; amines such as dimethylbenzylamine, triethylenediamine, benzyldimethylamine, and triethanolamine; organic phosphines such as triphenylphosphine, diphenylphosphine, and phenylphosphine; tetra-substituted phosphonium-tetra-substituted borates such as tetraphenylphosphonium ethyltriphenyl borate; and tetraphenyl boron salts such as 2-ethyl-4-methylimidazole tetraphenylborate.

When the resin composition contains a curing catalyst (E), the content of the curing catalyst (E) is preferably equal to or greater than 0.01 parts by mass with respect to 100 parts by mass in total of the epoxy compound (A) and the curing agent (C). On the other hand, the content of the curing catalyst (E) is preferably equal to or less than 0.1 parts by mass with respect to 100 parts by mass in total of the epoxy compound (A) and the curing agent (C).

### «Flame retardant (F)»

Adding a flame retardant (F) to the resin composition allows a cured product of the resin composition to have increased flame retardance.

Examples of the flame retardant (F) include, without limitation, phosphorus-based flame retardants and halogen-based flame retardants.

Examples of the phosphorus-based flame retardants include, without limitation, phosphoric acid esters, phosphazene, bisdiphenylphosphine oxide, and phosphinates. Specific examples of the phosphoric acid esters include a condensed phosphoric acid ester of dixylenyl phosphate. Specific examples of the phosphazene include phenoxyphosphazene. Specific examples of the bisdiphenylphosphine oxide include xylylene bisdiphenylphosphine oxide. Specific examples of the phosphinates include metal phosphinates of aluminum dialkyl phosphinates.

On the other hand, examples of the halogen-based flame retardants include, without limitation, ethylene dipentabromobenzene, ethylene bistetrabromoimide, decabromodiphenyl oxide, and tetradecabromodiphenoxybenzene.

The content of the flame retardant (F) is preferably equal to or greater than 5 parts by mass with respect to 100 parts by mass of the resin composition. On the other hand, the content of the flame retardant (F) is preferably equal to or less than 15 parts by mass with respect to 100 parts by mass of the resin composition.

### «Other components (G)»

The other components (G) are components other than the epoxy compound (A), the maleimide compound (B), the curing agent (C), the inorganic filler (D), the curing catalyst (E), and the flame retardant (F). Examples of the other components (G) include, without limitation, additives. Examples of the additives include, without limitation, dispersants, coupling agents, dyes, surfactants, and leveling agents. The other components (G) include resins other than the epoxy compound (A), resins other than the maleimide compound (B), and curing agents other than the curing agent (C). The other component(s) (G) may consist of only one type or include two or more types, whichever is appropriate.

### «Quantitative relationship between components»

The content of the epoxy compound (A) is preferably equal to or greater than 25 parts by mass, more preferably equal to or greater than 30 parts by mass, and even more preferably equal to or greater than 35 parts by mass, with respect to 100 parts by mass in total of the epoxy compound (A), the maleimide compound (B), and the curing agent (C). Setting the content of the epoxy compound (A) at 25 parts by mass or more may reduce the chances of causing not only a decrease in adhesiveness but also an increase in the water absorption rate of a cured product of the resin composition.

On the other hand, the content of the epoxy compound (A) is preferably equal to or less than 45 parts by mass, more preferably equal to less or than 42 parts by mass, and even more preferably equal to or less than 40 parts by mass, with respect to 100 parts by mass in total of the epoxy compound (A), the maleimide compound (B), and the curing agent (C). Setting the content of the epoxy compound (A) at 45 parts by mass or less may reduce the chances of causing not only a decrease in the glass transition temperature (Tg) of a cured product of the resin composition but also an increase in the coefficient of thermal expansion (CTE) of the cured product of the resin composition.

The content of the maleimide compound (B) is preferably equal to or greater than 25 parts by mass, more preferably equal to or greater than 30 parts by mass, and even more preferably equal to or greater than 32 parts by mass, with respect to 100 parts by mass in total of the epoxy compound (A), the maleimide compound (B), and the curing agent (C). Setting the content of the maleimide compound (B) at 25 parts by mass or more may reduce the chances of causing not only a decrease in the glass transition temperature (Tg) of a cured product of the resin composition but also an increase in the coefficient of thermal expansion (CTE) of the cured product of the resin composition.

On the other hand, the content of the maleimide compound (B) is preferably equal to or less than 45 parts by mass, more preferably equal to or less than 40 parts by mass, and even more preferably equal to or less than 35 parts by mass, with respect to 100 parts by mass in total of the epoxy compound (A), the maleimide compound (B), and the curing agent (C). Setting the content of the maleimide compound (B) at 45 parts by mass or less may reduce the chances of causing not only a decrease in adhesiveness but also an increase in the water absorption rate of a cured product of the resin composition.

### <Prepreg>

FIG. 1 illustrates a prepreg 1 according to this embodiment. The prepreg 1 has the shape of a sheet. The prepreg 1 includes at least one sheet of base member 12 and a resin layer 11. The base member 12 is impregnated with the resin composition. The resin layer 11 contains the resin composition. The resin composition is a semi-cured product.

The base member 12 is a reinforcing member and is not limited to any particular one. The base member 12 preferably has a thickness equal to or greater than 10 µm and more preferably has a thickness equal to or greater than 30 µm. On the other hand, the base member 12 preferably has a thickness equal to or less than 300 µm and more preferably has a thickness equal to or less than 200 µm.

Specific examples of the base member 12 include glass cloth, aramid cloth, polyester cloth, glass non-woven fabric, aramid non-woven fabric, polyester non-woven fabric, pulp paper, and linter paper. The types of glass cloth are preferably #7628, #1501, #2116, #1080, #1078, and #106.

In the manufacturing process of the prepreg 1, the glass cloth is preferably treated with a coupling agent before being impregnated with the resin composition in stage A. Treating the glass cloth with the coupling agent in this manner may increase the degree of adhesion between the glass cloth and the resin composition. Examples of the coupling agent include, without limitation, a coupling agent (already cited) which may be used in surface treatment of the inorganic filler (D).

A method for manufacturing the prepreg includes the steps of: impregnating the base member 12 with a resin composition in stage A; and heating the base member 12 until the resin composition impregnated into the base member 12 makes a transition to stage B. As used herein, the stage A refers to an initial stage on which the resin composition is soluble in a certain type of liquid and meltable. That is to say, the resin composition in stage A is a varnish.

### <Film with resin>

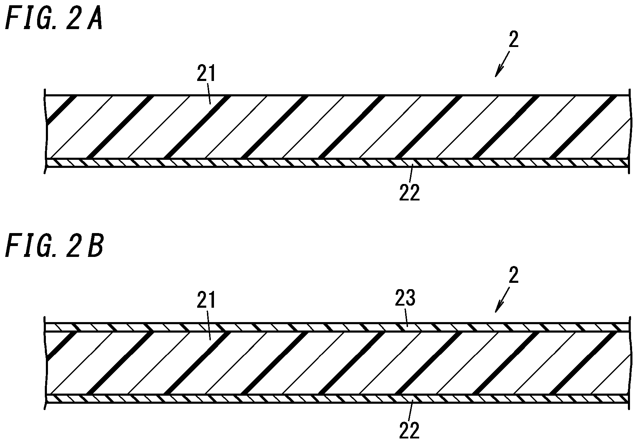

FIGS. 2A and 2B illustrate films 2 with resin according to this embodiment. Each of the films 2 with resin may be used, for example, to form a printed wiring board 5 with multiple levels (by buildup process). The film 2 with resin has the shape of a film as a whole. The film 2 with resin includes a resin layer 21 and a supporting film 22. FIG. 2A illustrates a film 2 with resin and with no protective film 23. FIG. 2B illustrates a film 2 with resin and with a protective film 23 as an additional member. Peeling the protective film 23 from the film 2 with resin shown in FIG. 2B may turn the film 2 with resin shown in FIG. 2B into the film 2 with resin shown in FIG. 2A.

The resin layer 21 contains the resin composition. The resin composition is a semi-cured product. When heated, the semi-cured product turns into a cured product. In this manner, the resin layer 21 may form an insulating layer.

The thickness of the resin layer 21 is not limited to any particular value but is preferably equal to or less than 120 µm, more preferably equal to or less than 100 µm, even more preferably equal to or less than 60 µm, and most preferably equal to or less than 40 µm. This allows the insulating layer to have a reduced thickness, thus reducing the overall thickness of the board as well. The resin layer 21 preferably has a thickness equal to or greater than 10 µm.

The supporting film 22 supports the resin layer 21 thereon. Making the supporting film 22 support the resin layer 21 in this way allows the resin layer 21 to be handled more easily.

The supporting film 22 may be an electrically insulating film, for example. Specific examples of the supporting film 22 include a polyethylene terephthalate (PET) film, a polyimide film, a polyester film, a polyparabanic acid film, a polyether ether ketone film, a polyphenylene sulfide film, an aramid film, a polycarbonate film, and a polyarylate film. However, these are only examples and the supporting film 22 does not have to be one of these films.

A release agent layer (not shown) may be provided on the surface, used to support the resin layer 21, of the supporting film 22. The release agent layer allows the supporting film 22 to be peeled off as needed from the resin layer 21. After the resin layer 21 has been cured to form an insulating layer, the supporting film 22 is preferably peeled off from the insulating layer.

Although one surface of the resin layer 21 is covered with the supporting film 22 in the example shown in FIG. 2A, the other surface of the resin layer 21 may be covered with a protective film 23 as shown in FIG. 2B. Covering both surfaces of the resin layer 21 in this manner with the supporting film 22 and the protective film 23, respectively, allows the resin layer 21 to be handled even more easily. This also reduces the chances of foreign particles adhering onto the resin layer 21.

The protective film 23 may be an electrically insulating film, for example. Specific examples of the protective film 23 include a polyethylene terephthalate (PET) film, a polyolefin film, a polyester film, and a polymethylpentene film. However, these are only examples and the protective film 23 does not have to be one of these films.

A release agent layer (not shown) may be provided on the surface, laid on top of the resin layer 21, of the protective film 23. The release agent layer allows the protective film 23 to be peeled off as needed from the resin layer 21.

### <Sheet of metal foil with resin>

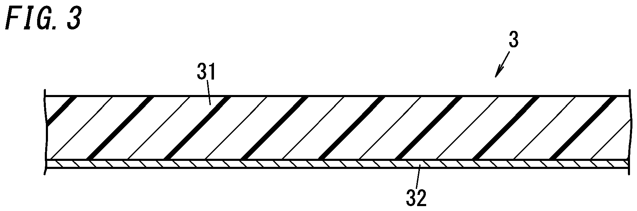

FIG. 3 illustrates a sheet of metal foil 3 with resin according to this embodiment. The sheet of metal foil 3 with resin has the shape of a film as a whole. The sheet of metal foil 3 with resin includes a resin layer 31 and a sheet of metal foil 32. The sheet of metal foil 3 with resin may be used to form a printed wiring board 5 with multiple levels (by buildup process).

The resin layer 31 contains the resin composition. The resin composition is a semi-cured product. When heated, the semi-cured product may turn into a cured product. In this manner, the resin layer 31 may form an insulating layer.

The thickness of the resin layer 31 is not limited to any particular value but is preferably equal to or less than 120 µm, more preferably equal to or less than 100 µm, even more preferably equal to or less than 60 µm, and most preferably equal to or less than 40 µm. This allows the insulating layer, which is formed by curing the resin layer 31, to have a reduced thickness, thus reducing the overall thickness of the board as well. The resin layer 31 preferably has a thickness equal to or greater than 10 µm.

The sheet of metal foil 32 is bonded to the resin layer 31. The sheet of metal foil 32 may specifically be, but does not have to be, a sheet of copper foil. The sheet of metal foil 32 may be patterned into conductor wiring 53 by having unnecessary portions thereof etched away by subtractive process, for example.

The thickness of the sheet of metal foil 32 is not limited to any particular value but is preferably equal to or less than 35 µm, and more preferably equal to or less than 18 µm. The sheet of metal foil 32 preferably has a thickness equal to or greater than 5 µm.

Optionally, the sheet of metal foil 32 may be configured as an extremely thin sheet of metal foil (such as an extremely thin sheet of copper foil) of a so-called "extremely thin sheet of metal foil with a carrier (not shown)." The extremely thin sheet of metal foil with the carrier has a triple layer structure. That is to say, the extremely thin sheet of metal foil with the carrier includes: the carrier; a peelable layer provided on the surface of the carrier; and an extremely thin sheet of metal foil provided on the surface of the peelable layer. The extremely thin sheet of metal foil is too thin to be handled easily by itself and is naturally thinner than the carrier. The carrier is a sheet of metal foil (such as a sheet of copper foil) that plays the role of protecting and supporting the extremely thin sheet of metal foil. The extremely thin sheet of metal foil with the carrier is relatively thick and thick enough to handle easily. The extremely thin sheet of metal foil preferably has a thickness equal to or greater than 1 µm. On the other hand, the extremely thin sheet of metal foil preferably has a thickness equal to or less than 10 µm. The extremely thin sheet of metal foil may be peeled off as needed from the peelable layer. The carrier preferably has a thickness equal to or greater than 18 µm. On the other hand, the carrier preferably has a thickness equal to or less than 35 µm.

When the extremely thin sheet of metal foil with the carrier is used, the sheet of metal foil 3 with resin may be manufactured in the following manner. Specifically, the resin composition is applied onto the surface of the extremely thin sheet of metal foil of the extremely thin sheet of metal foil with the carrier and heated to form a resin layer 31. Thereafter, the carrier is peeled off from the extremely thin sheet of metal foil. The extremely thin sheet of metal foil is bonded as a sheet of metal foil 32 to the surface of the resin layer 31. The peelable layer is preferably peeled off along with the carrier and should not be left on the surface of the extremely thin sheet of metal foil. Nevertheless, even if any part of the peelable layer remains on the surface of the extremely thin sheet of metal foil, the remaining part of the peelable layer is easily removable. The extremely thin sheet of metal foil bonded to the surface of the resin layer 31 may be used as a seed layer in a modified semi-additive process (MSAP). The conductor wiring 53 may be formed by subjecting the seed layer to an electrolytic plating process.

### <Metal-clad laminate>

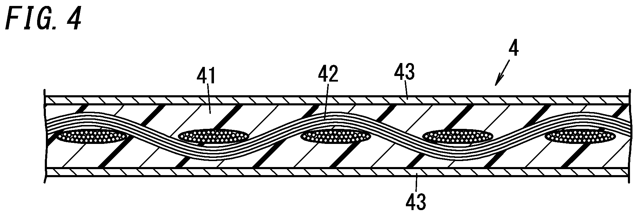

FIG. 4 illustrates a metal-clad laminate 4 according to this embodiment. The metal-clad laminate 4 includes an insulating layer 41 and at least one metal layer 43. The insulating layer 41 includes a cured product of at least one prepreg 1. As can be seen, the metal-clad laminate 4 may be manufactured with the prepreg 1 used as its material. The insulating layer 41 is a layer which has electrical insulation properties and is in an insoluble and non-meltable state. The metal layer 43 is bonded to the insulating layer 41.

The metal layer 43 is not limited to any particular one as long as the metal layer 43 is a layer containing a metal. Specifically, the metal layer 43 may be a sheet of copper foil. The metal layer 43 preferably has a thickness equal to or greater than 18 µm. On the other hand, the metal layer 43 preferably has a thickness equal to or less than 210 µm. The metal layer 43 preferably has a ten-point average roughness Rzjis equal to or greater than 5.0 µm. This may further increase the degree of adhesion between the insulating layer 41 and the metal layer 43.

A method for manufacturing the metal-clad laminate 4 includes the step of stacking a metal layer 43 such as a sheet of metal foil on one or both sides of a laminate made up of either one prepreg 1 or two or more prepregs 1 and heating and pressing the assembly, for example. Preferably, before the metal layer 43 is stacked on the laminate, the surface of the metal layer 43 (at least its surface to be laid on the laminate) is treated with a coupling agent. Treating the surface of the metal layer 43 with the coupling agent in this manner causes the coupling agent to bond the organic material in the prepreg 1 to the metal layer 43, thus further increasing the degree of adhesion between the insulating layer 41 and the metal layer 43. As the coupling agent, any of the exemplary ones described above may be used. The condition for heating and pressing is not limited to any particular one. FIG. 4 illustrates a metal-clad laminate 4 formed through the step of stacking a metal layer 43 on each of the two sides of the laminate consisting of one prepreg 1 and then heating and pressing the assembly.

### <Printed wiring board>

FIG. 5 illustrates a printed wiring board 5 according to this embodiment. The printed wiring board 5 includes at least one insulating layer 51 and at least one conductor layer 530.

The insulating layer 51 includes a cured product of at least one prepreg 1. The insulating layer 51 is a layer having electrical insulation properties and exhibiting an insoluble and non-meltable state.

The conductor layer 530 is bonded to the insulating layer 51. As used herein, the "conductor layer" refers to a layer with electrical conductivity such as a signal layer, a power supply layer, or a ground layer. The conductor layer 530 includes the conductor wiring 53.

Also, as used herein, the printed wiring board 5 is a term referring to not only a printed wiring board including at most two conductor layers 530 but also a multilevel printed wiring board including three or more conductor layers 530. Note that a printed wiring board including two conductor layers 530 and one insulating layer 51 is shown in FIG. 5.

The printed wiring board 5 may be manufactured by, for example, a subtractive process using the metal-clad laminate 4 as its material. Alternatively, the printed wiring board 5 may also be formed to have a multi-layer structure by a build-up process using the film 2 with resin and the sheet of metal foil 3 with resin.

The printed wiring board 5 may have one or more pieces of through hole plating 54. The through hole plating 54 may be formed by, for example, drilling a hole through the insulating layer 51, performing a desmear process on the hole, and then plating the inner wall of the hole with copper, for instance. The desmear process may be performed by, for example, permanganate method. Although not shown, the printed wiring board 5 may have one or more blind via holes. Note that the hole may be a through hole or a non-through hole, whichever is appropriate.

In this embodiment, the insulating layer 51 contains the silica-treated magnesium hydroxide (D2), thus improving the drillability and the desmear performance. This would reduce the chances of causing ion migration. Specifically, this reduces the chances of forming CAF along the base member 52 inside the insulating layer 51 (e.g., in the portion X shown in FIG. 5). Consequently, this may increase the long-term insulation reliability of the printed wiring board 5.

In addition, the insulating layer 51 contains the silica filler (D1), which would allow the insulating layer 51 to have a low coefficient of thermal expansion.

As can be seen from the foregoing description, this embodiment may reduce the chances of causing ion migration and achieve a low coefficient of thermal expansion.

### 3. Aspects

As can be seen from the foregoing description of embodiments, the present disclosure has the following aspects. In the following description, reference signs are inserted in parentheses just for the sake of clarifying correspondence in constituent elements between the following aspects of the present disclosure and the exemplary embodiments described above.

A first aspect is a resin composition, which contains an epoxy compound (A), a maleimide compound (B), a curing agent (C), and an inorganic filler (D). The inorganic filler (D) includes a silica filler (D1) and a silica-treated magnesium hydroxide (D2) that is a magnesium hydroxide subjected to surface treatment with silica.

This aspect may reduce the chances of causing ion migration and achieve a low coefficient of thermal expansion.

A second aspect is a resin composition which may be implemented in conjunction with the first aspect. In the second aspect, the curing agent (C) contains dicyandiamide (C1) and/or a polyfunctional phenolic compound (C2).

This aspect may improve adhesiveness and flame retardance.

A third aspect is a resin composition which may be implemented in conjunction with the second aspect. In the third aspect, the polyfunctional phenolic compound (C2) includes a phosphorus-containing compound (C21).

This aspect may further improve flame retardance.

A fourth aspect is a resin composition which may be implemented in conjunction with any one of the first to third aspects. In the fourth aspect, the content of the epoxy compound (A) is equal to or greater than 25 parts by mass and equal to or less than 45 parts by mass with respect to 100 parts by mass in total of the epoxy compound (A), the maleimide compound (B), and the curing agent (C).

According to this aspect, setting the content of the epoxy compound (A) at a value equal to or greater than 25 parts by mass may reduce the chances of not only causing a decrease in adhesiveness but also causing an increase in the water absorption rate of a cured product of the resin composition. In addition, setting the content of the epoxy compound (A) at a value equal to or less than 45 parts by mass may reduce the chances of not only causing a decrease in the glass transition temperature (Tg) of a cured product of the resin composition but also causing an increase in the coefficient of thermal expansion (CTE) of the cured product of the resin composition.

A fifth aspect is a resin composition which may be implemented in conjunction with any one of the first to fourth aspects. In the fifth aspect, the content of the maleimide compound (B) is equal to or greater than 25 parts by mass and equal to or less than 45 parts by mass with respect to 100 parts by mass in total of the epoxy compound (A), the maleimide compound (B), and the curing agent (C).

According to this aspect, setting the content of the maleimide compound (B) at a value equal to or greater than 25 parts by mass may reduce the chances of not only causing a decrease in the glass transition temperature (Tg) of a cured product of the resin composition but also causing an increase in the coefficient of thermal expansion (CTE) of the cured product of the resin composition. In addition, setting the content of the maleimide compound (B) at a value equal to or less than 45 parts by mass may reduce the chances of not only causing a decrease in adhesiveness but also causing an increase in the water absorption rate of a cured product of the resin composition.

A sixth aspect is a resin composition which may be implemented in conjunction with any one of the first to fifth aspects. In the sixth aspect, the content of the silica-treated magnesium hydroxide (D2) is equal to or greater than 1 part by mass and equal to or less than 20 parts by mass with respect to 100 parts by mass in total of the silica filler (D1) and the silica-treated magnesium hydroxide (D2).

According to this aspect, setting the content of the silica-treated magnesium hydroxide (D2) at a value equal to or greater than 1 part by mass may further reduce the chances of causing ion migration. Conversely, setting the content of the silica-treated magnesium hydroxide (D2) at a value equal to or less than 20 parts by mass may reduce the chances of causing a decrease in flame retardance.

A seventh aspect is a prepreg (1), which includes: a resin layer (11) containing the resin composition according to any one of the first to sixth aspects; and a base member (12) impregnated with the resin composition.

This aspect may reduce the chances of causing ion migration and achieve a low coefficient of thermal expansion.

An eighth aspect is a film (2) with resin, which includes: a resin layer (21) containing the resin composition according to any one of the first to sixth aspects; and a supporting film (22) supporting the resin layer (21).

This aspect may reduce the chances of causing ion migration and achieve a low coefficient of thermal expansion.

A ninth aspect is a sheet of metal foil (3) with resin, which includes: a resin layer (31) containing the resin composition according to any one of the first to sixth aspects; and a sheet of metal foil (32) bonded to the resin layer (31).

This aspect may reduce the chances of causing ion migration and achieve a low coefficient of thermal expansion.

A tenth aspect is a metal-clad laminate (4), which includes: an insulating layer (41) containing either a cured product of the resin composition according to any one of the first to sixth aspects or a cured product of the prepreg (1) according to the seventh aspect; and a metal layer (43) bonded to the insulating layer (41).

This aspect may reduce the chances of causing ion migration and achieve a low coefficient of thermal expansion.

An eleventh aspect is a printed wiring board (5), which includes: an insulating layer (51) containing either a cured product of the resin composition according to any one of the first to sixth aspects or a cured product of the prepreg (1) according to the seventh aspect; and conductor wiring (53) bonded to the insulating layer (51).

This aspect may reduce the chances of causing ion migration and achieve a low coefficient of thermal expansion.

### Examples

The present disclosure will be described specifically by way of specific examples. Note that the present disclosure is not limited to the following examples.

### [Materials]

The following materials were used as materials for resin compositions representing specific examples and comparative examples.

### <Epoxy compound (A)>

- Naphthalene epoxy resin, product name HP-9500 manufactured by DIC Corporation, having an epoxy equivalent of 220 to 240 g/eq.

### <Maleimide compound (B)>

- Phenylmethane maleimide, product name BMI-2300 manufactured by Daiwa Fine Chemicals Co., Ltd., having a functional group equivalent of 180 g/eq.

### <Curing agent (C)>

- Biphenyl-aralkyl phenolic resin, product name MEHC-7403H manufactured by Meiwa Plastic Industries Ltd., having a hydroxyl equivalent of 132 g/eq.
- Novolac phosphorus phenolic resin, product name XZ92741.00 manufactured by Dow Inc., having a phosphorus content of 9.6% by mass and a hydroxyl equivalent of 550 g/eq.

### <Inorganic filler (D)>

### «Silica filler (D1)»

- Spherical silica, product name BQ029 manufactured by Ginet New Material Technology Co., Ltd.

### «Silica-treated magnesium hydroxide (D2)»

- Silica-treated magnesium hydroxide, product name: MAGSEEDS EP1-S manufactured by Konoshima Chemical Co., Ltd., having a mean particle size of 2 µm.

### «Additional fillers (D3)»

- Silica-untreated magnesium hydroxide, product name: EP1-A manufactured by Konoshima Chemical Co., Ltd.
- Talc zinc molybdate, product name: Kemgard 911C manufactured by Huber Engineered Materials.
- Aluminum hydroxide, product name: ALH-F manufactured by Kawai Lime Industry Co., Ltd.

### <Curing catalyst (E)>

- Imidazole catalyst (2-ethyl-4-methylimidazole), product name 2E4MZ manufactured by Shikoku Chemicals Corporation.

### <Flame retardant (F)>

- Phosphoric acid ester 1: condensed phosphoric acid ester (non-halogen condensed phosphoric acid ester), aromatic condensed phosphoric acid ester, product name: PX-200 manufactured by Daihachi Chemical Industry Co., Ltd.
- Phosphoric acid ester 2: metal phosphinate, product name: OP935 manufactured by Clariant Chemicals Co., Ltd., having a phosphorus content of about 23% by mass.

### [Preparation of varnish]

These materials were compounded to have any of the compositions shown in Table 1. The compound was dissolved or dispersed in methyl ethyl ketone as a solvent so that the solid content thereof would be 70% by mass. Then, the mixture was stirred up with a disper. In this manner, varnishes respectively containing the resin compositions according to the examples and comparative examples were prepared.

### [Manufacturing of prepreg]

A prepreg was manufactured by using a piece of glass cloth (product name "#7628" manufactured by Nanya) as a base member, impregnating, at room temperature, the piece of glass cloth with the above-described varnish, and then heating the piece of glass cloth at a temperature of about 150°C for 4 to 5 minutes with a non-contact type heating unit and thereby drying and removing the solvent from the varnish to semi-cure the resin composition. The prepreg was prepared to have a resin content of 46% by mass.

### [Manufacturing of copper-clad laminate]

Four prepregs, each of which was manufactured as described above, were stacked one on top of another, and the stack of the prepregs was sandwiched between the roughened surfaces of two sheets of copper foil (with a thickness of 35 µm) and the assembly was heated and press-molded at a temperature of 220°C under a pressure of 2.94 MPa (= 30 kgf/cm²) for 90 minutes. In this manner, a copper-clad laminate (CCL), of which the insulating layer had an overall thickness of 800 µm, was manufactured.

### [Evaluation tests]

### (Glass transition temperature (Tg))

The sheets of copper foil of the copper-clad laminate were removed by etching to obtain an insulating substrate not covered with any sheet of copper foil (i.e., a so-called "unclad plate"). A disk-shaped sample was cut out from this insulating substrate. After this sample was dried, the glass transition temperature (Tg) was measured by dynamic mechanical analysis (DMA). Specifically, the dynamic mechanical analysis (DMA) was carried out using a bending module with a frequency set at 10 Hz. The temperature at which tan6 reached a local maximum when the temperature was increased from room temperature to 380°C at a temperature increase rate of 5°C/min was defined to be the glass transition temperature (Tg).

### (Gel time)

About 10 mL of the varnish was dripped onto a hot plate at 170°C and then held for 20 seconds. After that, the time it took for the varnish to turn no longer thready from a Teflon (R) rod due to a sufficient increase in its viscosity since the varnish started to be stirred with the Teflon rod was measured.

### (Coefficient of thermal expansion (CTE-Z))

The sheets of copper foil of the copper-clad laminate were removed by etching to obtain an unclad plate, from which a disk-shaped sample was cut out. After the sample was dried, the coefficient of thermal expansion (CTE-Z) in the thickness direction of the sample at a temperature equal to or lower than the glass transition temperature (Tg) was measured by TMA method. The measurement temperature was in the range from 30°C to 350°C and the temperature increase rate was 10°C/min.

### (Oven heat resistance)

The copper-clad laminate was cut into a plurality of pieces, each of which had a size of 5 cm square and was used as a sample. This sample was loaded into an oven at 270°C for 1 hour to see, with the naked eye, if any swelling had occurred to the sample. As used herein, the "swelling" refers to partially raised peeling that occurs between the insulating layers or between the insulating layer and the sheet of copper foil in the sample and is a form of delamination. The sample was graded by the following criteria:
Grade A: if no swelling was observed; or
Grade B: if swelling was observed at one or more points.

### (CAF resistance)

Wiring having 50 through holes at a pitch of 1.65 mm was formed on the copper-clad laminate to prepare a sample. The distance between the inner walls of the through holes was 0.87 mm. A voltage of 1000 V was applied to this sample for 1,000 hours in an atmosphere with a temperature of 85°C and a humidity of 85% RH. The resistance value (initial value) of the insulating layer before the application of the voltage and the resistance value of the insulating layer after the application of the voltage were measured. Then, the sample was graded according to CAF resistance by the following criteria:
Grade A: if the decrease in resistance value from the initial value was within one digit; or
Grade B: if the decrease in resistance value from the initial value was two digits or more.

### (Copper foil adhesiveness)

The copper foil adhesiveness (peel strength) of the copper-clad laminate was measured in compliance with the JIS C6481 standard.

### (Flame retardance)

A UL94 combustion test was conducted to evaluate the flame retardance. Specifically, the sheets of copper foil of the copper-clad laminate were removed by etching to obtain an unclad plate, from which a strip-shaped sample having a length of 125 mm and a width of 12.5 mm was cut out. This sample was attached vertically to a clamp and was exposed to 20 mm flames for 10 seconds twice. Based on its combustion behavior, the sample was graded V-0, V-1, V-2, or Not.

The results of these evaluation tests are summarized in the following Table 1:

**[Table 1]**

| | | | | Unit | Examples | | | | | | | Cmp. Ex. | |
|---|---|---|---|---|---|---|---|---|---|---|---|---|---|
| | | | | | 1 | 2 | 3 | 4 | 5 | 6 | 7 | 1 | 2 |
| | Maleimide compound (B) | Bismaleimide | | parts by mass | 35.0 | 25.0 | 45.0 | 35.0 | 35.0 | 35.0 | 35.0 | 35.0 | 35.0 |
| | Epoxy compound (A) | Naphthalene epoxy resin | | parts by mass | 39.8 | 45.9 | 33.7 | 39.8 | 39.8 | 39.8 | 39.8 | 39.8 | 39.8 |
| | Curing agent (C) | Biphenyl-aralkyl phenolic resin | | parts by mass | 19.1 | 22.0 | 16.2 | 19.1 | 19.1 | 19.1 | 19.1 | 19.1 | 19.1 |
| | | Novolac phosphorus phenolic resin (C2) (C21) | | parts by mass | 6.1 | 7.0 | 5.2 | 6.1 | 6.1 | 6.1 | 6.1 | 6.1 | 6.1 |
| | Curing catalyst (E) | Imidazole catalyst | | parts bv mass | 0.2 | 0.2 | 0.2 | 0.2 | 0.2 | 0.2 | 0.2 | 0.2 | 0.2 |
| Chemical Makeup of Resin Composition | Inorganic fillers (D) | Spherical silica (D1) | | parts by mass | 91.8 | 91.8 | 91.8 | 91.8 | 91.8 | 47.5 | 190.1 | 91.8 | 0.0 |
| | | Silica-treated magnesium hydroxide (D2) | | parts by mass | 4.8 | 4.8 | 4.8 | 1.0 | 18.4 | 2.5 | 9.9 | 0 | 4.8 |
| | | Additional Inorganic Fillers (D3) | Silica-untreated Magnesium hydroxide | parts by mass | 0 | 0 | 0 | 0 | 0 | 0 | 0 | 4.8 | 0 |
| | | | Talc zinc molybdate | parts by mass | 4.6 | 4.6 | 4.6 | 4.6 | 4.6 | 4.6 | 4.6 | 4.6 | 4.6 |
| | | | Aluminum hydroxide | parts by mass | 0 | 0 | 0 | 0 | 0 | 0 | 0 | 0 | 91.8 |
| | Flame retardant (F) | Phosphoric acid ester 1 | | parts bv mass | 4.3 | 4.3 | 4.3 | 4.3 | 4.3 | 4.3 | 4.3 | 4.3 | 4.3 |
| | | Phosphoric acid ester 2 | | parts by mass | 3.4 | 3.4 | 3.4 | 3.4 | 3.4 | 3.4 | 3.4 | 3.4 | 3.4 |
| Test results | Glass transition temperature (Tg) | | | °C | 271 | 271 | 270 | 270 | 272 | 271 | 276 | 271 | 270 |
| | Gel time | | | min: second | 8:15 | 8:15 | 3:45 | 5:40 | 5:46 | 7:15 | 3:24 | 4:34 | 2:30 |
| | Coefficient of thermal expansion (CTE-Z) | | | ppm/°C | 21 | 22 | 24 | 22 | 20 | 25 | 20 | 21 | 31 |
| | Oven heat resistance | | | - | A | A | A | A | A | A | A | A | B |
| | CAF resistance | | | - | A | A | A | A | A | A | A | B | A |
| | Copper foil adhesiveness | | | N/mm | 1.25 | 1.23 | 1.21 | 1.23 | 1.17 | 1.22 | 1.01 | 1.27 | 1.21 |
| | Flame retardance | | | - | V-0 | V-0 | V-0 | V-0 | V-0 | V-0 | V-0 | V-1 | V-0 |

### Reference Signs List

- 1: Prepreg
- 11: Resin Layer
- 12: Base Member
- 2: Film with Resin
- 21: Resin Layer
- 22: Supporting Film
- 3: Sheet of Metal Foil with Resin
- 31: Resin Layer
- 32: Sheet of Metal Foil
- 4: Metal-Clad Laminate
- 41: Insulating Layer
- 43: Metal Layer
- 5: Printed Wiring Board
- 51: Insulating Layer
- 53: Conductor Wiring

## Claims

1. A resin composition containing an epoxy compound (A), a maleimide compound (B), a curing agent (C), and an inorganic filler (D),
the inorganic filler (D) including a silica filler (D1) and a silica-treated magnesium hydroxide (D2) that is a magnesium hydroxide subjected to surface treatment with silica.

2. The resin composition of claim 1, wherein
the curing agent (C) contains dicyandiamide (C1) and/or a polyfunctional phenolic compound (C2).

3. The resin composition of claim 2, wherein
the polyfunctional phenolic compound (C2) includes a phosphorus-containing compound (C21).

4. The resin composition of claim 1, wherein
content of the epoxy compound (A) is equal to or greater than 25 parts by mass and equal to or less than 45 parts by mass with respect to 100 parts by mass in total of the epoxy compound (A), the maleimide compound (B), and the curing agent (C).

5. The resin composition of claim 1, wherein
content of the maleimide compound (B) is equal to or greater than 25 parts by mass and equal to or less than 45 parts by mass with respect to 100 parts by mass in total of the epoxy compound (A), the maleimide compound (B), and the curing agent (C).

6. The resin composition of claim 1, wherein
content of the silica-treated magnesium hydroxide (D2) is equal to or greater than 1 part by mass and equal to or less than 20 parts by mass with respect to 100 parts by mass in total of the silica filler (D1) and the silica-treated magnesium hydroxide (D2).

7. A prepreg comprising:
a resin layer containing the resin composition of any one of claims 1 to 6; and
a base member impregnated with the resin composition.

8. A film with resin, comprising:
a resin layer containing the resin composition of any one of claims 1 to 6; and
a supporting film supporting the resin layer.

9. A sheet of metal foil with resin, comprising:
a resin layer containing the resin composition of any one of claims 1 to 6; and
a sheet of metal foil bonded to the resin layer.

10. A metal-clad laminate comprising:
an insulating layer containing a cured product of the resin composition of any one of claims 1 to 6; and
a metal layer bonded to the insulating layer.

11. A printed wiring board comprising:
an insulating layer containing a cured product of the resin composition of any one of claims 1 to 6; and
conductor wiring bonded to the insulating layer.
